# EUROPÄISCHE PATENTANMELDUNG

(11) **EP 2 822 127 A2**
(43) Veröffentlichungstag der Anmeldung: **07.01.2015**
(21) Anmeldenummer: 14172769.3
(22) Anmeldetag: 17.06.2014
(51) Int. Cl.: H02H 3/44, H02J 4/00

(54) **Verfahren und Vorrichtung zur innenwiderstandsabhängigen Einstellung eines Laststroms**

(30) Priorität: 01.07.2013 DE 102013212821
(71) Anmelder: Bender GmbH & Co. KG, 35305 Grünberg (DE)
(72) Erfinder: Möll, Dipl.- Ing., Winfried, 35321 Laubach (DE)
(74) Vertreter: advotec.

(57) **Zusammenfassung**

Die Erfindung betrifft ein Verfahren und eine Vorrichtung zur Einstellung eines Laststroms während des Betriebs einer Last, die über Lastanschlüsse mit einer Versorgungsleitung eines Stromversorgungssystems verbunden ist. Dabei wird ein an den Lastanschlüssen wirksamer Innenwiderstand des Stromversorgungssystems bestimmt und zur Einstellung des Laststroms herangezogen.

Der Grundgedanke der vorliegenden Erfindung beruht auf der Bestimmung und Überwachung des Innenwiderstandes des versorgenden Stromnetzes, um mögliche Gefährdungen frühzeitig zu erkennen und geeignete Handlungsmaßnahmen einzuleiten. Anhand des bestimmten Innenwiderstandswertes kann eine Aussage über die Qualität des Stromversorgungssystems, wie beispielsweise einer Gebäudeinstallation, von dem Hauptstromverteiler über die Versorgungsleitung in dem speisenden Leitungsabgang bis zu den Lastanschlüssen getroffen werden.

## Beschreibung

Die Erfindung betrifft ein Verfahren und eine Vorrichtung zur Einstellung eines Laststroms während des Betriebs einer Last, die über Lastanschlüsse mit einer Versorgungsleitung eines Stromversorgungssystems verbunden ist.

Ausgehend von einer Schaltungsanordnung, bei der ein elektrischer Verbraucher als Last an eine Versorgungsleitung eines Stromversorgungssystems angeschlossen ist, muss im Hinblick auf die elektrische Sicherheit gewährleistet sein, dass der Laststrom über die Lastanschlüsse zu dem Verbraucher und damit auch der Strom in der Versorgungsleitung einen maximalen Wert nicht überschreitet. Gerade in älteren oder unzureichend abgesicherten Verteilanlagen des Stromversorgungssystems oder an Lastanschlüssen mit hohen Kontakt- oder Übergangswiderständen kann bei dem Betrieb mit hohen Lastströmen die Brandgefahr steigen, falls die Verlustleistung infolge eines erhöhten elektrischen Widerstands nicht abgeführt werden kann. Oftmals ist zwar hinsichtlich der Stromstärke eine maximale Belastbarkeit der Versorgungsleitung nominal bekannt, jedoch bleibt der aktuelle technische Zustand der Installation dabei außer Acht, so dass die Gefahr einer Überlastung besteht.

Zur weiteren Erläuterung der Aufgabenstellung sei im Folgenden als Beispiel für einen Lastbetrieb ein Ladevorgang eines Elektrofahrzeugs betrachtet. Dabei entspricht das Bordnetz des Elektrofahrzeuges mit dem aufzuladenden elektrischen Energiespeicher der Last und der in das Elektrofahrzeug fließende Ladestrom bildet den Laststrom.

Da die elektrischen Energiespeicher eines Elektrofahrzeugs regelmäßig aufgeladen werden, sind auch hier die Risiken zu beachten, die während des Ladevorgangs bestehen. Insbesondere wenn das Elektrofahrzeug zur Aufladung an eine handelsübliche Steckdose angeschlossen wird, muss sichergestellt sein, dass das dahinterliegende Stromversorgungsnetz auch für hohe Lastströme (Ladeströme) ausgelegt ist. So kann der Ladestrom, der über die Ladeanschlüsse einer Schuko- oder CEE-Steckdose fließt, bei ungesteuertem Laden (Lademodus 2) bis zu 32 A betragen.

Einige Ladegeräte bieten dabei eine Einstellmöglichkeit des Ladestroms. Der Benutzer kann einen reduzierten maximalen Ladestrom wählen, um diesen den Gegebenheiten der örtlichen Elektroinstallation anzupassen.

Insbesondere ist im Zuge der fortschreitenden Entwicklung zur Elektromobilität derzeit nicht sichergestellt, dass ein Elektrofahrzeug zur Aufladung stets an eine vorschriftsmäßig ausgeführte Elektroinstallation angeschlossen ist. Das sichere und zuverlässige Laden von Elektrofahrzeugen ist somit ebenso wie das Betreiben einer konventionellen Last unmittelbar mit dem elektrischen Zustand der Gebäudeinstallation verbunden. Dies gilt umso mehr, wenn bei dem Anschluss des Verbrauchers an handelsüblichen Steckdosen auch ungeeignete Verlängerungskabel verwendet werden.

Als Nachteil erweist sich bei den vorgenannten Anordnungen, dass während des Lastbetriebs der aktuelle elektrische Zustand des versorgenden Netzes, insbesondere hinsichtlich der Qualität seiner Versorgungsleitungen, nicht berücksichtigt wird.

Der vorliegenden Erfindung liegt somit die Aufgabe zu Grunde, ein Verfahren und eine Vorrichtung vorzuschlagen, welche die elektrische Sicherheit während des Betriebs einer Last an einer Versorgungsleitung eines Stromversorgungssystems erhöht.

Bezogen auf ein Verfahren wird diese Aufgabe in Verbindung mit dem Oberbegriff des Anspruchs 1 dadurch gelöst, dass ein an den Lastanschlüssen wirksamer Innenwiderstand des Stromversorgungssystems bestimmt und zur Einstellung des Laststroms herangezogen wird.

Der Grundgedanke der vorliegenden Erfindung beruht in vorteilhafterweise auf der Bestimmung und Überwachung des Innenwiderstandes des versorgenden Stromnetzes, um mögliche Gefährdungen frühzeitig zu erkennen und geeignete Handlungsmaßnahmen einzuleiten.

Als Innenwiderstand - im Folgenden mit Rᵢ benannt - wird hier der von außerhalb des Stromversorgungssystems an den Lastanschlüssen wirksame elektrische Widerstand des Stromversorgungssystems bezeichnet.

Anhand des bestimmten Innenwiderstandswertes Rᵢ kann eine Aussage über die Qualität des Stromversorgungssystems, wie beispielsweise einer Gebäudeinstallation, von dem Hauptstromverteiler über die Versorgungsleitung in dem speisenden Leitungsabgang bis zu den Lastanschlüssen getroffen werden.

In bevorzugter Ausgestaltung erfolgt während des Lastbetriebs eine ständige Überwachung des Innenwiderstands Rᵢ auf eine Überschreitung eines vorgebbaren Innenwiderstands-Grenzwertes.

Während des Lastbetriebs wird der Innenwiderstand Rᵢ kontinuierlich daraufhin überprüft, ob ein für das Stromversorgungssystem geltender spezifischer Innenwiderstands-Grenzwert überschritten wird. Ist eine derartige Verschlechterung feststellbar, so kann darauf automatisiert oder durch menschlichen Eingriff reagiert werden. Damit ist eine frühzeitige Erkennung kritischer Versorgungsstromkreise möglich, womit mögliche Brandschäden verhindert werden können.

Weiterhin werden zur Bestimmung des Innenwiderstands Rᵢ mindestens eine an den Lastanschlüssen zwischen einem Außenleiter und einem Neutralleiter anliegende Klemmenspannung Uₖ und der dazugehörige über die Lastanschlüsse fließender Laststrom I₁ gemessen.

Der bezüglich der Lastanschlüsse zwischen einem Außenleiter und dem Neutralleiter wirksame Innenwiderstand Rᵢ des Stromversorgungssystems wird durch eine Strom-/Spannungsmessung an einem bestimmten Klemmenpaar, beispielsweise L1 und N, ermittelt. Dazu wird die an den Lastanschlüssen anliegende Klemmenspannung Uₖ abgegriffen und der über diese Kontakte fließende Laststrom Iₗ gemessen. Neben der Heranziehung zur Bestimmung des Innenwiderstands Rᵢ kann aus dem Verlauf der gemessenen Klemmenspannung Uₖ auch eine Leistungsüberlastung infolge eines zu hohen Laststroms Iₗ, beispielsweise durch einen schadhaften Verbraucher, erkannt werden. Im Falle eines mehrphasigen Stromversorgungsnetzes erfolgt die Bestimmung mindestens eines Innenwiderstands Rᵢ, beispielsweise zwischen dem Außenleiter L1 und dem Neutralleiter N, es können aber auch alternativ oder zusätzlich die Innenwiderstände Rᵢ bezüglich der jeweiligen weiteren Außenleiter, beispielweise L2 und L3, und dem Neutralleiter N bestimmt, überwacht und zur Beurteilung der Qualität des Stromversorgungsnetzes herangezogen werden.

In weiterer vorteilhafter Ausgestaltung erfolgt die Bestimmung des Innenwiderstands Rᵢ durch eine Laststromänderung (ΔIₗ) bei gleichzeitiger Bestimmung einer Spannungsdifferenz (ΔU), welche sich aus der gemessenen Klemmenspannung (Uₖ) ergibt.

Für die Bestimmung des Innenwiderstandes Rᵢ wird der Laststrom Iₗ um einen Betrag ΔIₗ geändert und die sich daraus ergebende Spannungsdifferenz ΔU an den Lastanschlüssen durch Messung der Klemmenspannung Uₖ zur Berechnung des Innenwiderstands Rᵢ herangezogen. Erfolgt beispielsweise die Strom-/Spannungsmessung ausgehend von einer als konstant angenommenen Leerlaufspannung U₀, so gilt unter der weiteren Annahme der Gültigkeit einer linearen Strom/Spannungs-Beziehung (ohmsches Gesetz) dann für den Innenwiderstand Rᵢ = ΔU/ΔIₗ mit ΔU = U₀-Uₖ. Die Spannungsdifferenz ΔU kann aber auch in einem beliebigen Lastfall ohne Kenntnis der Leerlaufspannung U₀ bestimmt werden.

Mit Vorteil erfolgt die Laststromänderung ΔIₗ zur Bestimmung des Innenwiderstands Rᵢ durch eine impulsförmige Änderung des Laststroms ΔIₗ um einen vorgebbaren Betrag.

Mit dieser impulsförmigen Laststromänderung ΔIₗ, die einer kurzzeitigen Laststromänderung ΔIₗ in Form eines Messimpulses entspricht, wird bei gleichzeitiger Bestimmung der sich aus dieser Stromänderung ΔIₗ ergebenden Spannungsdifferenz ΔU eine Bestimmung des Innenwiderstands Rᵢ durchgeführt. Dabei kann bei einer Erhöhung des Laststroms dieser höchstens bis zu einem maximalen Laststrom Iₗₘₐₓ ansteigen. Unter einer impulsförmigen Laststromänderung ΔIₗ ist eine in Bezug auf typischerweise vorkommende Netzspannungsschwankungen, die langsamerer Natur sind und automatisch ausgeregelt werden, eine schnelle Änderung kurzer Dauer zu verstehen. Die Laststromänderung ΔIₗ und die korrespondierende Bestimmung der Spannungsdifferenz ΔU zur Bestimmung des Innenwiderstands Rᵢ werden damit nicht von den typischen, bei dem Betrieb eines Stromversorgungssystems auftretenden, Netzspannungsschwankungen beeinflusst.

Weiterhin wird die Bestimmung des Innenwiderstands Rᵢ manuell oder zeitgesteuert ausgelöst. Eine manuelle Auslösung der Bestimmung des Innenwiderstands Rᵢ kann von dem Anlagenbetreiber beispielsweise zu Beginn eines neu aufzunehmenden Lastbetriebs, insbesondere nach der Neuinstallation eines Verbrauches vor dessen erstmalige Inbetriebnahme, durchgeführt werden. Daneben bietet sich eine zeitgesteuerte Ausführung der Bestimmung des Innenwiderstands Rᵢ während des Lastbetriebs an, um über einen längeren Zeitraum hinweg schleichende Veränderungen in der Qualität des Stromversorgungssystems feststellen zu können. Hierzu bietet sich eine wiederholte Bestimmung in einstellbaren Zeitintervallen an.

Vorteilhafterweise wird die Bestimmung des Innenwiderstands Rᵢ während des Lastbetriebs durch eine betriebsbedingte Änderung des Laststroms Iₗ ausgelöst. Ergänzend zu einer manuellen oder zeitgesteuerten Bestimmung des Innenwiderstands Rᵢ kann diese auch in Abhängigkeit des zeitlichen Verlaufs des Laststroms Iₗ ausgelöst werden. Ändert sich der Laststrom unter verschiedenen Betriebs- oder Nutzungsbedingungen des Verbrauchers, wie z.B. die Stromaufnahme eines Elektroschweißgerätes, so kann diese Stromänderung dazu genutzt werden, eine Strom-/Spannungsmessung zur Bestimmung des Innenwiderstands Rᵢ auszulösen.

Bevorzugt ist ein maximaler Laststrom Iₗₘₐₓ voreinstellbar. Damit ist die Möglichkeit gegeben, die Qualität des versorgenden Stromnetzes im Vorfeld durch die Einstellung eines anlagenspezifischen maximalen Laststroms Iₗₘₐₓ zu berücksichtigen. Entweder kann so der Laststrom Iₗ aus Sicherheitsgründen auf einen maximalen Laststrom Iₗₘₐₓ begrenzt werden oder bei Gewissheit einer zuverlässig funktionierenden Installation kann die Last mit der für dieses Stromversorgungssystem maximal zulässigen Stromstärke betrieben werden.

Zur Einstellung des anlagenspezifischen maximalen Laststroms Iₗₘₐₓ kann dieser aus einer maximal zulässigen Verlustleistung Pᵥₘₐₓ in dem Stromversorgungssystem abgeleitet werden. Hierbei wählt der Benutzer nicht direkt einen maximalen Stromwert, sondern orientiert sich an der durch den Innenwiderstand Rᵢ des Stromversorgungssystems hervorgerufenen Verlustleistung, aus der ein verlustabhängiger maximaler Laststrom Iₗₘₐₓ berechnet werden kann. Beispielsweise besteht ab einer Verlustleistung von 60W im Lastkreis des Stromversorgungssystems bereits Brandgefahr. Der maximale Ladestrom Iₗₘₐₓ kann daher aus einer maximal zulässigen Verlustleistung Pᵥₘₐₓ, von beispielsweise 30W gemäß Iₗₘₐₓ = Pᵥₘₐₓ/ΔU abgeleitet werden, wobei ΔU die über dem Innenwiderstand Rᵢ des Stromversorgungssystems abfallende Spannung ist.

Zweckmäßigerweise erfolgt bei einer Überschreitung des Innenwiderstands-Grenzwertes eine Abschaltung des Lastbetriebs.

Um eine Gefährdung für Personen und Anlagen durch eine mögliche Brandentwicklung auszuschließen, wird der Lastbetrieb mittels einer Abschalteinrichtung unterbrochen, wenn der Innenwiderstand Rᵢ einen, gegebenenfalls anlagenspezifischen, Innenwiderstands-Grenzwert überschreitet. Im Falle der Aufladung eines elektrischen Energiespeichers eines Elektrofahrzeuges würde damit der Ladevorgang zumindest temporär beendet werden.

Alternativ zu der Abschaltung des Lastbetriebs kann bei einer Überschreitung des Innenwiderstands-Grenzwertes eine Reduktion des Laststroms Iₗ erfolgen.

Sofern der Verbraucher dafür ausgelegt ist, kann dieser bei geringerer Stromaufnahme und gegebenenfalls mit eingeschränkter Funktionalität weiter betrieben werden. Insbesondere kann im Falle der Aufladung eines Elektrofahrzeugs dadurch sichergestellt werden, dass bei einer während des Ladebetriebs auftretenden Verschlechterung der Qualität des Stromversorgungssystems eine Gefährdung durch Überlastung des Stromversorgungssystems nahezu ausgeschlossen ist, die Aufladung der Energiespeicher aber nicht unterbrochen wird.

In weiterer Ausgestaltung erfolgt in Kombination mit einer elektrischen Schutzeinrichtung in dem Stromversorgungssystem bei einer Überschreitung des Innenwiderstands-Grenzwertes eine Abschaltung eines die Last versorgenden Laststromkreises in dem Stromversorgungssystem.

In Verbindung mit einer in dem Stromversorgungssystem angeordneten Schutzeinrichtung kann somit bei Erkennung einer Überschreitung des Innenwiderstands-Grenzwertes eine Abschaltung zumindest des den Laststrom Iₗ führenden Teils des Stromversorgungsnetzes erfolgen. Die elektrische Sicherheit wird dadurch weiter gesteigert.

Vorzugsweise wird im Falle einer Auslösung einer Überstromschutzeinrichtung in einem die Last versorgenden Laststromkreis des Stromversorgungssystems der zugehörige Laststrom Iₗ aufgezeichnet und als ein Laststrom-Grenzwert verwendet.

Sollte die Überstromschutzeinrichtung in dem Stromversorgungssystem infolge eines zu hohen über die Lastanschlüsse fließenden Laststroms Iₗ auslösen, so kann der im Moment der Auslösung vorherrschende Laststrom Iₗ aufgezeichnet und in einem darauffolgenden Lastbetrieb als Laststrom-Grenzwert verwendet werden. Aus diesem Laststrom-Grenzwert kann dann alternativ mit einem Sicherheitsabschlag der maximale Laststrom Iₗₘₐₓ abgeleitet werden. Damit wird eine erneute Auslösung der Überstromschutzeinrichtung in dem Stromversorgungssystem infolge eines zu hohen Laststroms Iₗ bei einer Wiederaufnahme des Lastbetriebs vermieden.

In weiterer Ausgestaltung wird mindestens ein Schwellwert für den Innenwiderstand Rᵢ berechnet, bei dessen Überschreitung eine Warnmeldung ausgelöst wird.

Durch die Warnmeldung wird der Benutzer auf einen sich verschlechternden oder bevorstehenden kritischen Zustand des versorgenden Stromnetzes hingewiesen und kann dazu veranlasst werden, die Anlage überprüfen zu lassen, bevor ein Störfall eintritt.

In bevorzugter Ausführung wird mittels eines Ladestroms als Laststrom Iₗ ein Ladevorgang eines elektrischen Energiespeichers durchgeführt. Das erfindungsgemäße Verfahren eignet sich besonders für die Überwachung eines Ladevorgangs eines elektrischen Energiespeichers, da die Ladestromstärke in der Regel nicht an einen bestimmten, konstanten Stromwert gebunden ist. Der Ladevorgang kann somit als Lastbetrieb aufgefasst werden, wobei der Ladestrom dem Laststrom Iₗ entspricht. Durch die Einstellung des Laststroms Iₗ unter Zuhilfenahme des errechneten Innenwiderstands Rᵢ kann der Energiespeicher mit einem für das versorgende Netz angepassten, möglichst maximalen, Laststrom Iₗ geladen werden.

Mit Vorteil wird bei dem Ladevorgang der elektrische Energiespeicher eines mit einem Ladegerät versehenen Elektrofahrzeugs aufgeladen, wobei das Elektrofahrzeug mit einem Ladekabel über die Lastanschlüsse mit der Versorgungsleitung des Stromversorgungssystems verbunden ist.

Neben der Aufladung stationärer Energiespeicher kann das erfindungsgemäße Verfahren bei der Aufladung der elektrischen Energiespeicher von Elektrofahrzeugen angewendet werden. Dabei ist das Elektrofahrzeug mit dem Ladekabel über eine Steckvorrichtung, welche die Lastanschlüsse umfasst, mit der Versorgungsleitung des Stromversorgungssystems verbunden.

Bezogen auf eine Vorrichtung wird die der Erfindung zu Grunde liegende Aufgabe in Verbindung mit dem Oberbegriff des Anspruchs 17 gelöst durch eine Strom- und eine Spannungsmesseinrichtung zur Bestimmung eines an den Lastanschlüssen wirksamen Innenwiderstands Rᵢ des Stromversorgungssystems.

In Umsetzung des erfindungsgemäßen Verfahrens weist die erfindungsgemäße Vorrichtung eine Strom- und eine Spannungsmesseinrichtung auf. Aus den an den Lastanschlüssen erfassten Strom- und Spannungswerten kann der an diesen "Klemmen" wirksame Innenwiderstand Rᵢ des Stromversorgungssystems bestimmt werden. Die Strommesseinrichtung kann dabei als Differenzstrommesseinrichtung ausgeführt sein.

In weiterer vorteilhafter Ausgestaltung umfasst die Vorrichtung eine Vergleichseinrichtung zur Überwachung des Innenwiderstands Rᵢ auf eine Überschreitung eines vorgebbaren Innenwiderstands-Grenzwertes.

Entsprechend dem Grundgedanken der vorliegenden Erfindung wird der berechnete Innenwiderstand Rᵢ durch Vergleich mit einem Innenwiderstands-Grenzwert auf eine Überschreitung hin überwacht, um eine Aussage über den momentanen Zustand und damit die Qualität der Installation des Stromversorgungssystems zu erhalten.

Weiterhin weist die Vorrichtung eine Einstelleinrichtung zur Änderung des Laststroms Iₗ für die Bestimmung des Innenwiderstands Rᵢ und zur Reduktion des Laststroms Iₗ bei einer Überschreitung des Innenwiderstands-Grenzwertes auf.

Der Innenwiderstand Rᵢ wird gemäß der Beziehung Rᵢ = ΔU/ΔIₗ aus der Änderung des Laststroms ΔIₗ und der sich daraufhin einstellenden Spannungsänderung ΔU berechnet. Um die Stromänderung ΔIₗ für diese Berechnung sowie bei einer Überschreitung des Innenwiderstands-Grenzwertes gegebenenfalls eine Reduktion des Laststroms Iₗ vornehmen zu können, weist die Vorrichtung diese Einstelleinrichtung auf. Dabei kann auch eine Reduktion des Laststroms Iₗ auf den Wert Null erfolgen, was einer Unterbrechung des Lastbetriebes entspricht.

Zur Abschaltung des Lastbetriebs weist die Vorrichtung weiterhin eine Abschalteinrichtung auf. Bei einer Überschreitung des Innenwiderstands-Grenzwertes kann alternativ oder in Ergänzung nach einer anfänglichen Reduktion des Laststroms Iₗ eine Abschaltung des Lastbetriebs mittels der Abschaltvorrichtung erfolgen.

In weiterer vorteilhafter Ausgestaltung weist die Vorrichtung eine Recheneinheit zur Verknüpfung der gemessenen und voreingestellten Werte sowie eine Steuereinheit zur Ablaufsteuerung der Mess- und Berechnungsaufgaben auf.

Die Recheneinheit führt auf der Grundlage der gemessenen sowie der voreingestellten und gespeicherten Strom- und Spannungswerte die Berechnungen zur Bestimmung des Innenwiderstands Rᵢ aus. Die Steuereinheit kann als Mikrocontroller ausgeführt sein und legt die zeitliche Abfolge der Verfahrensschritte fest. So bestimmt die Steuereinheit beispielsweise wann und auf Grund welcher Ereignisses eine erneute Bestimmung des Innenwiderstands Ri durchgeführt werden soll.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigen:
- **Fig. 1:**: eine schematische Darstellung eines Stromversorgungsnetzes mit einer erfindungsgemäßen Vorrichtung zur Einstellung eines Laststroms,
- **Fig. 2:**: eine Anwendung des Verfahrens zur Aufladung eines Energiespeichers eines Elektrofahrzeugs.

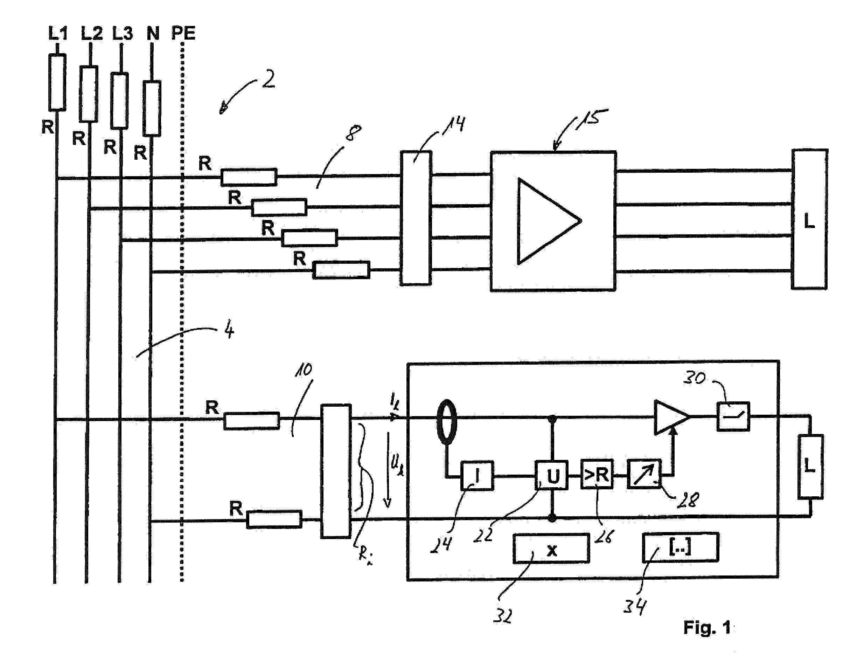

Die **Fig. 1** zeigt ein Stromversorgungssystem 2, das als geerdetes 3-phasiges Versorgungsnetz mit den aktiven Leitern L1, L2, L3 und N sowie dem Schutzleiter PE ausgeführt ist. Das Stromversorgungssystem 2 besteht aus dem Hauptsystem 4 und einer von dem Hauptsystem 4 abzweigenden 3-phasigen Versorgungsleitung 8 sowie einer weiteren von dem Hauptsystem 4 abzweigenden einphasigen Versorgungsleitung 10. An die Versorgungsleitungen 8, 10 ist jeweils als Verbraucher eine Last L über Lastanschlüsse 14 angeschlossen In den Versorgungsleitungen 8, 10 ist jeweils zwischen den Lastanschlüssen 14 und der Last L eine erfindungsgemäße Vorrichtung 15 geschaltet. Die Leitungs- und Übergangswiderstände des Stromversorgungssystems 2 sind als konzentrierte Verlustwiderstände R dargestellt.

Für die einphasige Versorgungsleitung 10 seien die Funktionsweise des erfindungsgemäßen Verfahrens und die dieses Verfahren umsetzende erfindungsgemäße Vorrichtung 15 näher erläutert. Die Vorrichtung 15 zur Einstellung eines Laststroms Iₗ weist eine Spannungsmesseinrichtung 22 und eine Strommesseinrichtung 24 auf. Die Spannungsmesseinrichtung 22 misst die an den Lastanschlüssen 14 zwischen dem Leiter L1 und dem Neutralleiter N auftretende Klemmenspannung Uₖ, und die Strommesseinrichtung 24 den über die Leiter L1 und N der Versorgungsleitung 10 fließenden Laststrom Iₗ, der durch die Last L fließt. Durch die Strom-/Spannungsmessung wird der von den Ladeanschlüssen 14 aus "gesehene" Innenwiderstand Rᵢ des Stromversorgungssystems 2 bestimmt, der sich im Wesentlichen aus den Verlustwiderständen R ergibt und eine Aussage über den elektrischen Zustand des Stromversorgungssystems 2 erlaubt.

Als weitere Funktionsblöcke umfasst die erfindungsgemäße Vorrichtung 15 eine Vergleichseinrichtung 26 zur Überwachung des Innenwiderstands Rᵢ auf eine Überschreitung eines vorgebbaren Innenwiderstands-Grenzwertes, eine Einstelleinrichtung 28 zur Änderung und Reduktion des Laststroms Iₗ, eine Abschalteinrichtung 30 zur Unterbrechung des Lastbetriebs, eine Recheneinheit 32 zur Verknüpfung der gemessenen und voreingestellten Werte sowie eine Steuereinheit 34 zur Ablaufsteuerung der Mess- und Berechnungsaufgaben.

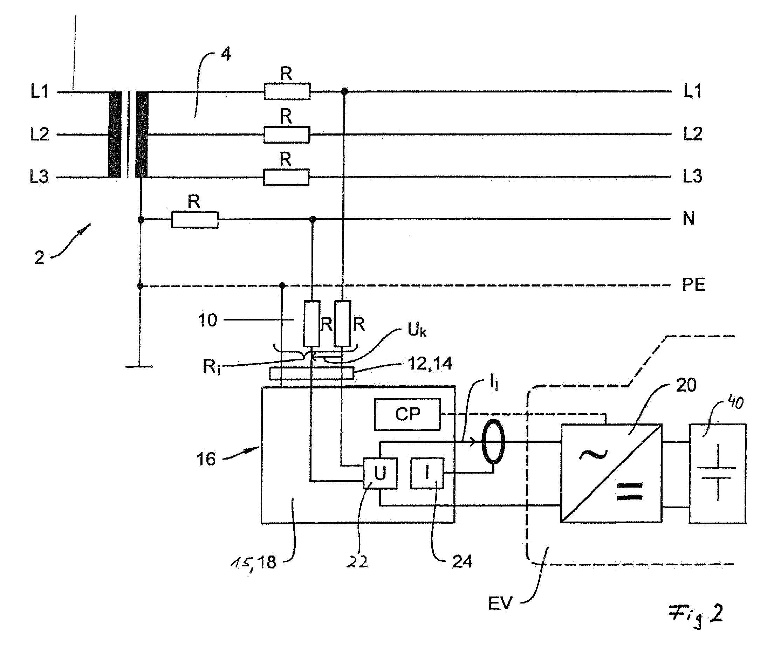

**Fig.2** zeigt eine Anwendung des erfindungsgemäßen Verfahrens zur Aufladung eines Energiespeichers 40 eines Elektrofahrzeugs EV mittels eines bordeigenen Ladegerätes 20. Das Elektrofahrzeug EV ist über eine Steckvorrichtung 12 mit Lastanschlüssen (Ladeanschlüssen) 14 und mittels Ladekabel 16 an die Leiter L1, N und PE der Versorgungsleitung 10 angeschlossen.

Zur Erfüllung der normativen Sicherheitsanforderungen ist bei der Aufladung des elektrischen Energiespeichers 40 des Elektrofahrzeugs EV an einer handelsüblichen Steckdose (Lademodus 2) in dem Ladekabel 16 eine mobile Schutzeinrichtung 18 (IC-CPD - In-Cable Control and Protective Device) mit einer Pilotfunktion (CP - Control Pilot) zur Kommunikation mit dem in dem Elektrofahrzeug EV befindlichen Ladegerät 20 vorgesehen.

Die aus dem Stand der Technik bekannte Schutzeinrichtung 18 ist um die erfindungsgemäße Funktionalität der innenwiderstandsabhängigen Einstellung des Laststroms Iₗ erweitert worden, so dass die derart modifizierte Schutzeinrichtung 18 den Funktionsumfang der erfindungsgemäßen Vorrichtung 15 umfasst und damit die Bestimmung eines an den Lastanschlüssen 14 wirksamen Innenwiderstands Rᵢ des Stromversorgungssystems 2 sowie die Einstellung des Laststroms Iₗ ermöglicht. In dem dargestellten Ausführungsbeispiel sind lediglich die Funktionen der Spannungsmessung 22 und der Strommessung 24 gezeigt. Daneben umfasst die modifizierte Schutzeinrichtung 18 auch die nicht dargestellten Funktionsblöcke Vergleichseinrichtung (26), Einstelleinrichtung (28), Abschalteinrichtung (30), Recheneinheit (32) und Steuereinheit (34).

Alternativ zu einer vollständigen Implementierung des erfindungsgemäßen Verfahrens in die Schutzeinrichtung 18 kann die erfindungsgemäße Vorrichtung 15 auch wie in **Fig. 1** dargestellt als separate funktionale Einheit in das Ladekabel 16 integriert oder als separate bauliche Einheit diesem vorgeschaltet sein oder auf mehrere bauliche Einheiten einschließlich der Schutzeinrichtung 18 verteilt angeordnet sein.

Wie in dem Ausführungsbeispiel mit einer allgemeinen Last L in **Fig. 1** misst die Spannungsmesseinrichtung 22 an den Lastanschlüssen 14 - hier in der Funktion als Ladeanschlüsse - die auftretende Klemmenspannung Uₖ, die auch als Versorgungsspannung auf das Ladegerät 20 des Elektrofahrzeugs EV geschaltet wird. Die Strommesseinrichtung 24 misst den über die Versorgungsleitung 10 fließenden Laststrom Iₗ, der als Ladestrom dem Ladegerät 20 des Elektrofahrzeugs EV zugeführt wird. Diese Strom-/Spannungsmessung lässt mittels der erfindungsgemäßen Bestimmung und Überwachung des an den Lastanschlüssen 14 wirksamen Innenwiderstand Rᵢ des Stromversorgungssystems 2 eine Aussage über den elektrischen Zustand des Stromversorgungssystems 2 zu und ermöglicht ein Anpassung des Ladestroms (Laststroms Iₗ) an die Qualität des Versorgungsnetzes.

Ein Steuersignal zur Einstellung des Laststroms Iₗ kann mittels der Pilotfunktion CP an das im Elektrofahrzeug EV befindliche Ladegerät 20 weitergeleitet werden.

Eine Warnmeldung kann unmittelbar an der Schutzeinrichtung 18 durch eine optische und/oder akustische Anzeige erfolgen oder kann mittels CP-Signal an das fahrzeuginterne Ladegerät 20 weitergeleitet und in dem Elektrofahrzeug EV zur Anzeige gelangen.

## Patentansprüche

1. Verfahren zur Einstellung eines Laststroms (Iₗ) während des Betriebs einer Last (L), die über Lastanschlüsse (14) mit einer Versorgungsleitung (10) eines Stromversorgungssystems (2) verbunden ist,
**dadurch gekennzeichnet,**
**dass** ein an den Lastanschlüssen (14) wirksamer Innenwiderstand (Rᵢ) des Stromversorgungssystems (2) bestimmt und zur Einstellung des Laststroms (Iₗ) herangezogen wird.

2. Verfahren nach Anspruch 1,
**dadurch gekennzeichnet,**
**dass** während des Lastbetriebs eine ständige Überwachung des Innenwiderstands (Rᵢ) auf eine Überschreitung eines vorgebbaren Innenwiderstands-Grenzwertes erfolgt.

3. Verfahren nach Anspruch 1 oder 2,
**dadurch gekennzeichnet,**
**dass** zur Bestimmung des Innenwiderstands (Rᵢ) mindestens eine an den Lastanschlüssen (14) zwischen einem Außenleiter (L1, L2, L3) und einem Neutralleiter (N) anliegende Klemmenspannung (Uₖ) und der dazugehörige über die Lastanschlüsse (14) fließende Laststrom (Iₗ) gemessen werden.

4. Verfahren nach Anspruch 3,
**dadurch gekennzeichnet,**
**dass** die Bestimmung des Innenwiderstands (Rᵢ) erfolgt durch eine Laststromänderung (ΔIₗ) bei gleichzeitiger Bestimmung einer Spannungsdifferenz (ΔU), welche sich aus der gemessenen Klemmenspannung (Uₖ) ergibt.

5. Verfahren nach Anspruch 4,
**dadurch gekennzeichnet,**
**dass** die Laststromänderung (ΔIₗ) zur Bestimmung des Innenwiderstands (Rᵢ) durch eine impulsförmige Änderung des Laststroms (Iₗ) um einen vorgebbaren Betrag erfolgt.

6. Verfahren nach einem der Ansprüche 1 bis 5,
**dadurch gekennzeichnet,**
**dass** die Bestimmung des Innenwiderstands (Rᵢ) manuell oder zeitgesteuert ausgelöst wird.

7. Verfahren nach einem der Ansprüche 1 bis 6,
**dadurch gekennzeichnet,**
**dass** die Bestimmung des Innenwiderstands (Rᵢ) während des Lastbetriebs durch eine betriebsbedingte Änderung des Laststroms Iₗ ausgelöst wird.

8. Verfahren nach einem der Ansprüche 1 bis 7,
**dadurch gekennzeichnet,**
**dass** ein maximaler Laststrom (Iₗₘₐₓ) voreinstellbar ist.

9. Verfahren nach Anspruch 8,
**dadurch gekennzeichnet,**
**dass** der maximale Laststrom (Iₗₘₐₓ) aus einer maximal zulässigen Verlustleistung (Pᵥₘₐₓ) in dem Stromversorgungssystem (2) abgeleitet wird.

10. Verfahren nach einem der Ansprüche 2 bis 9,
**dadurch gekennzeichnet,**
**dass** bei einer Überschreitung des Innenwiderstands-Grenzwertes eine Abschaltung des Lastbetriebs erfolgt.

11. Verfahren nach einem der Ansprüche 2 bis 9,
**dadurch gekennzeichnet,**
**dass** bei einer Überschreitung des Innenwiderstands-Grenzwertes eine Reduktion des Laststroms (Iₗ) erfolgt.

12. Verfahren nach einem der Ansprüche 2 bis 11,
**dadurch gekennzeichnet,**
**dass** in Kombination mit einer elektrischen Schutzeinrichtung in dem Stromversorgungssystem (2) bei einer Überschreitung des Innenwiderstands-Grenzwertes eine Abschaltung eines die Last (L) versorgenden Laststromkreises in dem Stromversorgungssystem (2) erfolgt.

13. Verfahren nach einem der Ansprüche 1 bis 12,
**dadurch gekennzeichnet,**
**dass** im Falle einer Auslösung einer Überstromschutzeinrichtung in einem die Last (L) versorgenden Laststromkreis des Stromversorgungssystems (2) der zugehörige Laststrom (Iₗ) aufgezeichnet und als ein Laststrom-Grenzwert verwendet wird.

14. Verfahren nach einem der Ansprüche 1 bis 13,
**dadurch gekennzeichnet,**
**dass** mindestens ein Schwellwert für den Innenwiderstand (Rᵢ) berechnet wird, bei dessen Überschreitung eine Warnmeldung ausgelöst wird.

15. Verfahren nach einem der Ansprüche 1 bis 14,
**dadurch gekennzeichnet,**
**dass** mittels eines Ladestroms als Laststrom (Iₗ) ein Ladevorgang eines elektrischen Energiespeichers (40) durchgeführt wird.

16. Verfahren nach Anspruch 15,
**dadurch gekennzeichnet,**
**dass** bei dem Ladevorgang der elektrische Energiespeicher (40) eines mit einem Ladegerät (20) versehenen Elektrofahrzeugs (EV) aufgeladen wird, wobei das Elektrofahrzeug mit einem Ladekabel (16) über die Lastanschlüsse (14) mit der Versorgungsleitung (10) des Stromversorgungssystems (2) verbunden ist.

17. Vorrichtung zur Einstellung eines Laststroms (Iₗ) während des Betriebs einer Last (L), die über Lastanschlüsse (14) mit einer Versorgungsleitung (10) eines Stromversorgungssystems (2) verbunden ist,
**gekennzeichnet durch**
eine Strom- (24) und eine Spannungsmesseinrichtung (22) zur Bestimmung eines an den Lastanschlüssen (14) wirksamen Innenwiderstands (Rᵢ) des Stromversorgungssystems (2).

18. Vorrichtung nach Anspruch 17,
**gekennzeichnet durch**
eine Vergleichseinrichtung (26) zur Überwachung des Innenwiderstands (Rᵢ) auf eine Überschreitung eines vorgebbaren Innenwiderstands-Grenzwertes.

19. Vorrichtung nach Anspruch 17 oder 18,
**gekennzeichnet durch**
eine Einstelleinrichtung (28) zur Änderung des Laststroms (Iₗ) für die Bestimmung des Innenwiderstands (Rᵢ) und zur Reduktion des Laststroms (Iₗ) bei einer Überschreitung des Innenwiderstands-Grenzwertes.

20. Vorrichtung nach einem der Ansprüche 17 bis 19,
**gekennzeichnet durch**
eine Abschalteinrichtung (30) zur Abschaltung des Lastbetriebs bei einer Überschreitung des Innenwiderstands-Grenzwertes.

21. Vorrichtung nach einem der Ansprüche 17 bis 20,
**gekennzeichnet durch**
eine Recheneinheit (32) zur Verknüpfung der gemessenen und voreingestellten Werte.

22. Vorrichtung nach einem der Ansprüche 17 bis 21,
**gekennzeichnet durch**
eine Steuereinheit (34) zur Ablaufsteuerung der Mess- und Berechnungsaufgaben.
